# EUROPÄISCHE PATENTSCHRIFT

(11) **EP 1 314 208 B1**
(45) Veröffentlichungstag und Bekanntmachung des Hinweises auf die Patenterteilung: **28.03.2007**
(21) Anmeldenummer: 01971929.3
(22) Anmeldetag: 20.08.2001
(51) Int. Cl.: H01L 31/18, H01L 31/0224, H01L 31/052, H01L 31/0392

(54) **MULTIKRISTALLINE LASERKRISTALLISIERTE SILICIUM-DÜNNSCHICHT SOLARZELLE AUF EINEM GLASSUBSTRAT**
MULTICRYSTALLINE LASER-CRYSTALLIZED SILICON THIN LAYER SOLAR CELL DEPOSITED ON A GLASS SUBSTRATE
CELLULE SOLAIRE A COUCHE MINCE DE SILICIUM MULTICRISTALLINE CRISTALLISEE PAR LASER, SUR UN SUBSTRAT EN VERRE

(30) Priorität: 31.08.2000 DE 10042733
(43) Veröffentlichungstag der Anmeldung: 28.05.2003
(73) Patentinhaber: INSTITUT FÜR PHYSIKALISCHE HOCHTECHNOLOGIE E.V., 07745 Jena (DE)
(72) Erfinder: FALK, Fritz, 07743 Jena (DE); ANDRÄ, Gudrun, 07749 Jena (DE)
(74) Vertreter: Grünberg, Thomas
(86) Internationale Anmeldenummer: PCT/EP2001/009571
(87) Internationale Veröffentlichungsnummer: WO 2002/019437

(56) Entgegenhaltungen:
- DE-C- 19 825 635
- US-A- 4 330 363
- US-A- 4 665 278
- BERGMANN R B ET AL: "CRYSTALLINE SILICON FILMS BY CHEMICAL VAPOR DEPOSITION ON GLASS FOR THIN FILM SOLAR CELLS" CONFERENCE RECORD OF THE 25TH. IEEE PHOTOVOLTAIC SPECIALISTS CONFERENCE 1996. WASHINGTON, MAY 13 - 17, 1996, CONFERENCE RECORD OF THE IEEE PHOTOVOLTAIC SPECIALISTS CONFERENCE, NEW YORK, IEEE, US, Bd. CONF. 25, 13. Mai 1996 (1996-05-13), Seiten 365-370, XP000896927 ISBN: 0-7803-3167-2
- ANDRA G ET AL: "Preparation of thick polycrystalline silicon layers on glass by laser irradiation" THIN SOLID FILMS, ELSEVIER-SEQUOIA S.A. LAUSANNE, CH, Bd. 318, Nr. 1-2, 15. April 1998 (1998-04-15), Seiten 42-45, XP004138560 ISSN: 0040-6090 in der Anmeldung erwähnt
- R.B. BERGMANN ET AL.: "High rate, low temperature deposition of crystalline silicon films for thin film solar cells on glass" 2ND WORLD CONFERENCE ON PHOTOVOLTAIC SOLAR ENERGY CONVERSION, Bd. II, 6. - 10. Juli 1998, Seiten 1260-1265, XP002189120 VIENNA; AT in der Anmeldung erwähnt
- KOHLER J R ET AL: "Large-grained polycrystalline silicon on glass by copper vapor laser annealing" THIN SOLID FILMS, ELSEVIER-SEQUOIA S.A. LAUSANNE, CH, Bd. 337, Nr. 1-2, 11. Januar 1999 (1999-01-11), Seiten 129-132, XP004197113 ISSN: 0040-6090
- ANDRA G ET AL: "Laser induced crystallization: a method for preparing silicon thin film solar cells" CONFERENCE RECORD OF THE 26TH IEEE PHOTOVOLTAIC SPECIALISTS CONFERENCE - 1997. PVSC '97. ANAHEIM, CA, SEPT. 29 - OCT. 3, 1997, IEEE PHOTOVOLTAIC SPECIALISTS CONFERENCE, NEW YORK, NY: IEEE, US, 29. September 1997 (1997-09-29), Seiten 639-642, XP010267866 ISBN: 0-7803-3767-0
- G. ANDRÄ ET AL.: "Preparation of single crystalline regions in amorphous silicon layers on glass by Ar+ laser irradiation" APPLIED SURFACE SCIENCE, Bd. 154-155, Februar 2000 (2000-02), Seiten 123-129, XP001059803 Amsterdam, NL in der Anmeldung erwähnt
- PATENT ABSTRACTS OF JAPAN vol. 1999, no. 1, 22. Dezember 1999 (1999-12-22) & JP 11 251611 A (KYOCERA CORP), 17. September 1999 (1999-09-17) in der Anmeldung erwähnt

## Beschreibung

Die Erfindung betrifft im Gegensatz zu amorphen Silizium-Dünnschicht-Solarzellen (z.B. WO 81/01914) eine multikristalline laserkristallisierte Silicium-Dünnschicht-Solarzelle auf Glas, die für eine Beleuchtung von der Substratseite ausgelegt ist. Obgleich die bei multikristallinen Silicium-Dünnschicht-Solarzellen mit den für multikristallines Material typischen großen Kristalliten zu erwartenden Vorteile, nämlich ein hoher Wirkungsgrad von mehr als 15% bei gleichzeitigem geringen Siliciumverbrauch und geringst möglichen Schichtdicken, den Fachleuten seit Jahren geläufig sind, sind derartige Solarzellen auf Glas, das nur geringe Temperaturen bis 600 °C oder allenfalls 700 °C aushält, nicht beschrieben worden. Die genannten hohen Wirkungsgrade wurden bisher für inultikristalline Silicium-Dünnschicht-Solarzellen auf nichttransparenten Hochtemperatursubstraten erzielt. Ein Beispiel für eine multikristalline Zelle mit Beleuchtung von der dem Substrat abgewandten Seite aus ist in "18,2 % Efficient Multicrystalline Silicon Cell", Jianhua Zhao et al, 26. PVSC (Photovoltaic Specialists Conference), Seiten 227-230, Sept. 1997, Anaheim, CA, gezeigt. Die Ausdehnung der Körner in der dort beschriebenen multikristallinen Waferstruktur liegen zwischen 0,1 mm² und 1 cm².

Substrate aus Glas und eine Beleuchtung von der Substratseite aus sind deshalb anzustreben, weil so auf der dem Substrat abgewandten Seite eine einfach herzustellende flächige Metallelektrode verwendet werden kann. Zur Erzielung einer Beleuchtungsmöglichkeit von der Substratseite aus werden in bisher realisierten Solarzellen transparente, leitfähige Oxide (TCO) auf dem Glassubstrat als Gegenelektrode verwendet, die aber nur geringe Temperaturen (geringer als 300 °C) bei der Zellprozessierung aushalten. Ein solcher Zellaufbau ist z.B. in der US 4 665 278 für eine Zelle auf der Basis von amorphem und mikrokristallinem (µc) Siliciummaterial beschrieben, mit der Besonderheit, dass die Metallelektrode auf der dem Substrat abgewandten Seite als ebener Rückreflektor genutzt wird.

Der Wirkungsgrad in kommerziell hergestellten amorphen Silizium-Solarzellenmodulen, die bekanntermaßen kostengünstig herstellbar sind, beträgt jedoch nur um 8%. Bei den sogenannten mikrokristallinen Siliciumzellen mit einer feinkristallinen Siliciumschicht mit amorphem Anteil (µc-Si:H-Zellen) ist die Beleuchtung von der Substratseite prinzipiell möglich, obgleich diese Zellen in der Regel mit Lichteinfall von der dem Substrat abgewandten Oberseite aus arbeiten. Ein Nachteil der mikrokristallinen Struktur liegt darin, dass die zahlreich vorhandenen Komgrenzen ungünstige elektrische Eigenschaften haben, was den Wirkungsgrad der Zellen begrenzt. Maximale Wirkungsgrade für mikrokristalline Laborzellen liegen derzeit bei etwa 12%.

Um dem geschilderten Nachteil zu begegnen, wurden gemäß der JP 11-186 585 (PAJ-Abstract) die Siliciumschichten im CVD-Verfahren so auf das Glas gebracht, dass sich in üblicher Weise unmittelbar feinkristallines Silicium, allerdings mit columnaren Wachstumsstrukturen abscheidet. Zwar verlaufen hierbei die zahlreich vorhandenen Korngrenzen parallel zur Stromrichtung, sie liegen jedoch in geringem Abstand voneinander, was zu ungünstigen elektrischen Eigenschaften führt, die letztlich den Wirkungsgrad der Zelle begrenzen. Die erzielte einheitliche Orientierung der Kristallite in den texturierten Schichten scheint eine günstige Wirkung auf den Wirkungsgrad zu haben. Texturierte Schichten mit Vorzugsorientierung der Kristallite wurden auch gemäß der JP 7-94 766 A erzeugt. Diese Schrift offenbart spezielle mikrokristalline Silizium-Schichtfolgen auf Glas über einer Antireflexionsschicht, nämlich zum einen eine Folge aus vier Schichten: p⁺, p, n, n ⁺ bzw. n⁺, n, p, p⁺ oder zum anderen eine Folge aus drei Schichten: p⁺, n, n⁺ bzw. n⁺, p, p⁺, wobei eine flächige Elektrode über dem Schichtstapel liegt. Die einzelnen Siliciumschichten werden mit jeweils einer Dicke zwischen 20 nm und maximal 500 nm erzeugt und mit einem gepulsten UV-Laser laserkristallisiert, um eine einheitliche Kristallorientierung zu erzielen. Die Korngrößen sind mit größer 50 nm angegeben. Hierbei ist allerdings zu beachten, dass bekanntermaßen die mit einem gepulsten UV-Laser erzielbaren Korngrößen stets unter 1 µm liegen. Ferner ist noch angegeben, dass ein epitaktisches Aufwachsen nicht erforderlich sei und daher die Temperatur für die Schichtbildung herabgesetzt werden könnte. Die in dieser Schrift aufgezeigte Schichtfolge findet sich in nachfolgenden Entwicklungen derselben Autoren mit p⁺, p, n⁺- oder pin-Strukturen und Säulenwachstum nicht wieder.

Größere Kristallite zur Vermeidung der oben aufgezeigten Nachteile lassen sich mit direkter Abscheidung zwar erzeugen, aber nur dann, wenn so hohe Substrattemperaturen gewählt werden, dass Glas als Substrat nicht in Frage kommt. Daneben existiert die aufwendige Möglichkeit, Zellen durch Transfer von quasi-mono-kristallinen Siliciumschichten auf Glas oder Kunststoff herzustellen und auch hierdurch eine Bestrahlung von der Substratseite aus zu realisieren. In diesem Fall wird eine von einem Silizium-Wafer abgetrennte Siliziumschicht mittels einer Klebeschicht zusammen mit einer Elektrodenfolie auf dem Substrat aufgeklebt.

Ein Überblick über die derzeitigen Ausbildungsmöglichkeiten für kristalline Silicium-Dünnschicht-Solarzellen findet sich in "Crystalline Si thin-film solar cells: a review", R. B. Bergmann, Appl. Phys. A 69 (1999), Seiten 187 bis 194. Auch dort ist ausgeführt, dass hohe Wirkungsgrade sich entweder nur mit den unverhältnismäßig dicken, aus Siliciumwafem hergestellten Zellen oder mit den erwähnten Zellen aus quasi-monokristallinen Siliciumschichten herstellen lassen, mit dem zusätzlichen Nachteil, dass die Zellfläche an die Wafergröße gebunden ist. Ferner ist ausgeführt, dass bei dem angestrebten multikristallinen Silicium mit großen Kristalliten bisher erfolgreich nur mit Hochtemperatursubstraten gearbeitet wird, wenn man vergleichbare Wirkungsgrade erzielen will.

In "Preparation of single crystalline regions in amorphous silicon layers on glass by Ar⁺ laser irradiation", G. Andrä et al, Appl. Surface Science 154-155 (2000), Seiten 123 bis 129, ist ein Verfahren erläutert, mit dem man große Kristallite in kristallinen Siliciumschichten für Solarzellen und z.B. für mikroelektronische Bauelementen auch bei Verwendung von Glassubstraten erzielen kann. Hierzu wird eine amorphe Siliciumschicht mit einem Ar⁺ Laser bestrahlt. Mit der dort beschriebenen überlappenden Laserbestrahlung konnten durch Laserkristallisation in den a-Si:H Schichten Korngößen von über 100 µm erzielt werden. In "Preparation of thick polycrystalline silicon layers on glass by laser irradiation", G. Andrä et al, Thin Solid Films 318 (1998), Seiten 42 bis 45, ist ferner erläutert, dass man nach Aufbringen einer grobkörnigen kristallinen Keimschicht durch Kristallisation einer amorphen Siliciumschicht mit einem Ar⁺ Laser diese Keimschicht in ihrer Dicke vergrößern kann, ohne die laterale Ausdehnung der Kristallite zu ändern, wenn man während der weiteren Beschichtung mit einem gepulsten Excimerlaser bestrahlt. Damit sind prinzipiell Korngrößen im Bereich von über 10µm bis 100 µm möglich, die größer als die Mindestschichtdicken für die Siliciumschicht einer Silicium-Dünnschichtsolarzelle sind. Speziell für mikroelektronische Bauelemente ist ferner in der DE 198 25 635 C1 ein Laserkristallisationsverfahren aufgezeigt, das mit Kurzpulslasern, z.B. Kupferdampflasern oder frequenzverdoppelnden Nd:YAG- Lasern arbeitet, um Korndurchmesser von mehr als 1 µm zu erzielen. Einheitliche Korngrößen von deutlich mehr als 10 µm, wie sie für Solarzellen anzustreben wären, sind jedoch durch dieses Verfahren nicht möglich.

Das Dokument: 25th IEEE Photovoltaic Specialists Conference, Washington, USA, 13-17 Mai 1996, Seiten 365-370 beschreibt eine multikristalline Silicium-Dünnschicht-Solarzelle auf einem Glassubstrat aufweisend: eine weniger als 1 µm dicke multikristalline Si-Schicht die auf dem Substrat liegt und als Keimschicht dient; eine zweite multikristalline Si-Schicht, die mehrere µm dick und p-dotiert ist, und als Absorberschicht dient; eine auf der Absorberschicht liegende n-dotiente Si-Schicht als Emitterschicht; und eine Gitterelektrode- auf der Emitterschicht.

Der Erfindung liegt die Aufgabe zugrunde, eine derartig große Korngrößen aufweisende multikristalline laserkristallisierte Silicium-Dünnschicht-Solarzelle auf Glas anzugeben, die für eine Beleuchtung von der Glassubstratseite ausgelegt ist. Ferner soll ein Verfahren zur Herstellung einer solchen Solarzelle angegeben werden.

Diese Aufgabe wird durch den Gegenstand der unabhängigen Ansprüche gelöst. Bevorzugte Weiterbildungen sind in den Unteransprüchen definiert.

Die erfindungsgemäße Solarzelle umfaßt mit ihrer Keimschicht eine transparente Elektrode auf der beleuchteten Zellenseite aus dem gleichen Material wie die auf die Keimschicht folgende Absorberschicht, nämlich aus multikristallinem laserkristallisierten Silicium großer Kristallite. Diese weisen eine laterale Dimension, d.h. Ausdehnung in Substratebene auf, die größer als die Schichtdicke der aus Keimschicht und Absorberschicht, gegebenenfalls auch noch Emitterschicht bestehenden multikristallinen Siliciumschicht ist. Damit beträgt die laterale Dimension im allgemeinen deutlich über 10 µm. Senkrecht zum Substrat setzen sich die Körner der Keimschicht in der Absorberschicht, gegebenenfalls auch Emitterschicht fort und weisen damit eine der Gesamtdicke dieser Schichten entsprechende Größe auf. Die Kristallite müssen in Dickenrichtung keine Vorzugsorientierung haben, was den Herstellungsprozess vereinfacht.

Während die Keimschicht und Absorberschicht stets aus multikristallinem Silicium bestehen, kann die Emitterschicht auch aus mikrokristallinem Silicium-Material mit Körnern von vorzugsweise 5 bis 500 nm Ausdehnung bestehen. Durch die Körnigkeit der Absorberschicht ist die Oberfläche der darauf liegenden vergleichsweise dünn ausbildbaren Emitterschicht ebenfalls rauh. Bei mikrokristalliner Emitterschicht wird die Oberfläche durch deren Feinkörnigkeit zusätzlich rauh. Dadurch bilden Absorberschicht, Emitterschicht und eine hierauf angebrachte rückreflektierende Kontaktschicht (vorzugsweise Metallschicht) eine Lichtfallenanordnung.

Diese Merkmale sind gegenüber bekannten multikristallinen und auch feinkristallinen Siliciumzellen neu und vorteilhaft. Die gleichzeitig als Elektrode dienende Keimschicht kann im Gegensatz zu den bekannten Zellen direkt auf dem transparenten Glassubstrat sitzen, das z.B. aus Borosilikatglas besteht. Damit ist eine einfach herstellbare Zelle geschaffen, die die Möglichkeit der Realisierung der hohen Wirkungsgrade auf Grund der großen Kristallite und der inhärenten Lichtfallenstruktur bietet. Gegenüber den aufgezeigten bekannten multikristallinen Zellen sind die Material- und Herstellungskosten verringert. Die Zelle läßt sich großflächig herstellen, da Glas als Substrat in beliebiger Größe zur Verfügung steht.

In "High rate, low temperature deposition of crystalline silicon films for thin film solar cells on glass", R.B. Bergmann et al, 2nd World Conference and Exhibition on Photovoltaic Solar Energy Conversion, 6.-10. Juli 1998, Wien, Seiten 1260 bis 1265, ist in einem Schichtaufbau für eine Simulationszelle zwar eine hoch p-dotierte laserkristallisierte Keimschicht auf einem Glassubstrat beschrieben. Diese Keimschicht ist jedoch Teil einer Zelle mit Lichteinfall von der dem Glassubstrat abgewandten Seite, welches mit einer lichtreflektierenden Beschichtung auf der Unterseite versehen ist. Die zu beleuchtende Emitterschicht auf einer p-dotierten polykristallinen Absorberschicht ist demgemäß ultradünn und besteht aus einer amorphen Siliciumschicht. Zudem wird mit einer texturierten Oberfläche auf der Lichteinfallseite der Zelle zur Erzielung eines Lichtfalleneffekts gearbeitet. Die polykristalline Absorberschicht wächst durch epitaktische ionenunterstützte Abscheidung (IAD) auf der mikro- oder polykristallinen Keimschicht auf. Die Keimschicht wird durch Laserkristallisation mit einem gepulsten Kupferdampflaser erzeugt, wobei sich Kristallite mit länglichen Kornstrukturen mit einigen zehn µm Länge und wenigen µm Breite bilden. Die Simulationszellen mit dem besagten Schichtaufbau werden offenbar nach einem ebenfalls in dieser Schrift schematisch angegebenen Zellenaufbau gestaltet, in dem ein unterbrochener Frontkontakt auf der Lichteinfallseite der Zelle und ein durchgehender Rückkontakt auf der Substratseite vorgesehen ist.

Im Gegensatz zu den ansonsten technisch realisierten Solarzellen mit Lichteinfall von der Glassubstratseite aus wird in der erfindungsgemäßen Zelle die übliche TCO-Schicht vermieden. Die stattdessen auf dem Glassubstrat sitzende Keimschicht in Form der transparenten Siliciumelektrode dient nicht nur dazu, die bei der Laserkristallisation zur Erzielung der gewünschten großen Korngrößen auftretenden hohen Temperaturen größer 1000 °C zu ermöglichen, die eine TCO-Schicht nicht überstehen würde. Sie verhält sich als Elektrode zudem ähnlich wie das TCO und ermöglicht, dass auf der dem Substrat abgewandten Seite flächig ein Standard-Elektrodenmaterial wie Aluminium oder Silber mit niedrigem Schmelzpunkt verwendet werden kann, zumal an diese obere Elektrode keine Anforderungen an die Temperaturbeständigkeit gestellt werden müssen. Das ist von besonderem Vorteil, da diese Metalle ein nahezu perfekter Reflektor für das Sonnenlicht sind.

Durch das Glassubstrat erreicht man eine kostengünstigere Zellvariante als bei Verwendung von Hochtemperatursubstraten, die deutlich teurer als Glas sind. Eine Kosten verursachende Zwischenschicht zwischen Glassubstrat und kristalliner Siliciumschicht z.B. in Form einer Metallelektrode oder einer Pufferschicht als Diffusionsbarriere gegen Verunreinigungsatome aus dem Substrat ist nicht notwendig, aber möglich. Dies gilt auch für eine Antireflexionsschicht.

Bevorzugt wird das in Standardborosilikatgläsern (z.B. Corning 7059 oder Borofloat von Schott) ohnehin vorhandene Bor für die Dotierung oder zumindest für einen Teil der Dotierung der Keim- und Absorberschicht genutzt. Mit anderen Worten sind in der erfmdungsgemäßen Zelle nicht nur Diffusionsbarrieren zum Substrat vermieden, sondern es wird sogar gezielt sonst unerwünschtes Dotiermaterial im Glas genutzt. Für die alternative Zelle mit n-dortierter Absorberschicht können beispielsweise phophorhaltige Substrate verwendet werden.

Das in den Ansprüchen definierte Verfahren zur Herstellung der erfindungsgemäßen Zelle ist schnell und kostengünstig durchführbar. Durch das Laser-Verfahren während der Schichtabscheidung wird das Glassubstrat nicht beschädigt. Dennoch können die zum Wachstum von großen Kristalliten notwendigen hohen Temperaturen, die über dem Schmelzpunkt von Silicium liegen, und die erforderlichen Heizzeiten realisiert werden. Insbesondere, wenn die Dotierung für Keimschicht und Absorberschicht ganz oder teilweise aus dem Substrat als Dotieratomlieferant während der jeweiligen Laserbestrahlung erfolgt, sind auch keinerlei aufwendige Parameter hinsichtlich der Dotierung zu beachten. Für die Keimschicht, die Absorberschicht und die Emitterschicht können gleiche Abscheideverfahren eingesetzt werden, wobei lediglich die Laserbehandlung unterschiedlich ist.

Somit kann erfindungsgemäß direkt auf Glas, das nur begrenzte Temperaturen zuläßt, durch eine Kombination von Beschichtung und Laserkristallisation eine Solarzelle aus multikristallinem Silicium mit einer minimalen Anzahl unterschiedlicher Materialschichten aufgebaut werden. Dabei wird kein besonderes, hochtemperaturverträgliches Glas als Substrat benötigt. Das Glas braucht nicht mit einer besonderen temperaturstabilen Elektrodenschicht oder Diffusionsbarrierenschicht gegen Verunreinigungen aus dem Glas versehen werden. Wie bei einer Reihe von Dünnschichtsolarkonzepten üblich, brauchen keine laterale Dotierstrukturen eingebracht werden. Durch Kombination der prozeßbedingten Oberflächenrauhigkeit und der Elektrodenbeschichtung wird zugleich ein Lichtfalleneffekt erzeugt.

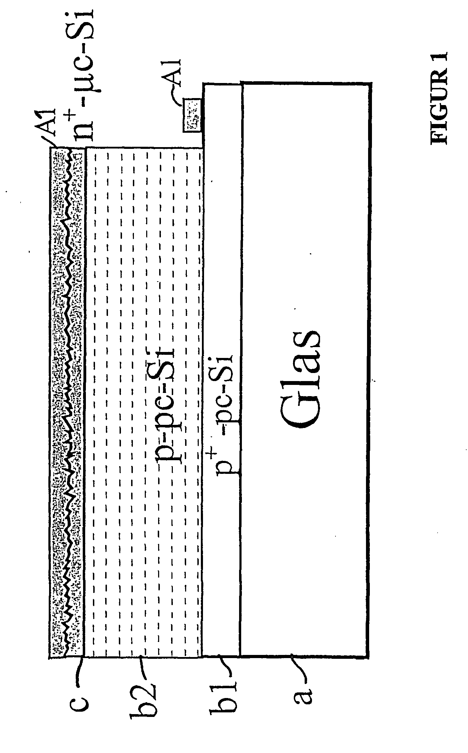

Im folgenden wird die Erfindung anhand der Zeichnung näher erläutert. Die Figur 1 zeigt eine schematische Darstellung eines Ausführungsbeispiels der erfindungsgemäßen Solarzelle. Auf einem ebenen oder strukturierten dotandenhaltigen, vorzugsweise borhaltigen Glassubstrat a, z.B. aus einem Borosilikatglas mit einem Gehalt von etwa 15 Gew.% Boroxid, befindet sich eine laserkristallisierte multikristalline Siliciumschicht b (pc steht für multikristallin) mit einer Dicke zwischen 2 µm und vorzugsweise maximal etwa 30 µm. Das Glassubstrat kann zur Erzeugung eines Lichtfalleneffektes selbst aufgerauht sein. Im Gegensatz hierzu ist gemäß der JP 11-274 536 A eine zusätzliche feinkörnige Schicht auf dem Glassubstrat vorgesehen. Die Kristallite der Schicht b weisen durchgängig eine laterale Kantenlänge auf, die größer als die jeweilige Schichtdicke ist, und die Korngrenzen der Kristallite durchlaufen somit die Schicht b durchgehend vom Glassubstrat zur Oberfläche. Der untere Bereich b1 der Schicht b direkt auf dem Glassubstrat mit einer bevorzugten Schichtdicke zwischen 150 nm und 1,5 µm ist hoch p-dotiert (10¹⁸ bis 6·10²⁰ cm⁻³, bevorzugt mehr als 10¹⁹ cm⁻³ Dotieratome) und hat die Doppelfunktion einer Keimschicht und einer transparenten hochleitfahigen Elektrode, die lokal entsprechend der Abbildung kontaktiert wird, vorzugsweise mit Aluminiumstreifen A1. Derartige Kontaktierungen sind prinzipiell auch aus anderen Zellen bekannt, z.B. JP 11-251 611 A (PAJ-Abstract).

Der über der Keimschicht liegende Schichtbereich b2 ist schwächer p-dotiert (mit zwischen 10¹⁵ bis 10¹⁸ cm⁻³ Dotieratomen) und dient als Absorberschicht. Die Absorberschicht b2 weist eine Dicke von etwa 1 bis 30 µm und eine homogene oder von der Grenzfläche zur Keimschicht b1 graduierlich abnehmende Dotierkonzentration auf. Die Dotierung der Absorberschicht b2 ist geringer als in der Keimschicht. Die Dotierkonzentration der Absorberschicht b2 sollte dabei an der Grenzfläche zur Emitterschicht c bevorzugt einen Wert aufweisen, der mindestens um den Faktor 100 geringer ist als in der Keimschicht b1. Auf dieser multikristallinen Absorberschicht b2 befindet sich eine durchgängig laserkristallisierte vorzugsweise hoch n-dotierte Emitterschicht c einer Dicke zwischen 5 und 100 nm mit gleicher, d.h. weitergeführter Kristallstruktur oder mit feinkristalliner Struktur aus Kristalliten mit Kantenlängen zwischen 5 und 500 nm, bevorzugt 20 und 500 nm. Die Emitterschicht kann, allerdings ohne irgendeinen Vorteil, auch dicker ausgeführt werden. Die Emitterschicht c weist eine Dotierung von etwa 10¹⁸ bis 2·10²¹ cm⁻³ Dotieratomen, bevorzugt mehr als 10¹⁹ cm⁻³ Dotieratomen und vorzugsweise in Form von Phosphor auf. Auf der Emitterschicht befindet sich eine Metallkontaktschicht A1 aus Aluminium (alternativ auch z.B. aus Silber), die im Gegensatz zu einem in der US 4 665 278 beschriebenen einfachen Reflektor gleichzeitig als strukturierter oder diffuser Rückreflektor der bereits erwähnten Lichtfallenanordnung dient. Durch die Rauhigkeit der Grenze zwischen Silicium und Metall wird der Lichtfalleneffekt bewirkt. Die Zelle wird von der Glassubstratseite beleuchtet.

Die angegebenen Dicken für die einzelnen Schichten sind speziell betreffend die obere Grenze nicht unbedingt einzuhalten. Allerdings wird die Zelle bei Überschreiten der angegebenen Dickenwerte, abgesehen davon, dass der Materialverbrauch unnötig steigt, keine Steigerung des Wirkungsgrades mehr zeigen. Vielmehr wird sogar damit zu rechnen sein, dass die Stromausbeute schlechter wird. Die Dicke der multikristallinen Schicht sollte nicht weniger als 2 µm betragen. Wenn somit die Keimschichtdicke nur 150 nm beträgt, sollte die Absorberschichtdicke nicht am unteren Grenzwert von 1 µm liegen, sondern entsprechend dicker ausgebildet werden.

Als Alternative zu der beschriebenen Zellstruktur: Substrat / p⁺ (Keimschicht) / p (Absorber) / n⁺ (Emitter) / Reflektor ist auch folgende Zellstruktur möglich: Substrat / n⁺ (Keimschicht) / n (Absorber) / p⁺ (Emitter) / Reflektor. Auf einem ebenen oder strukturierten Glas, das alternativ n-dotierende Bestandteile, vorzugsweise Phosphor, enthält, hat diese Zelle bis auf die Dotandenverteilung den gleichen Aufbau. In diesem Fall befindet sich auf der Glasseite eine hoch n-dotierte Keimschicht, die Absorberschicht ist leicht n-dotiert und auf der höher p-dotierten Emitterschicht befindet sich der Reflektor, der gleichzeitig die obere Elektrode ist. Wenn die Diffusion aus dem Glas durch eine Zwischenschicht (Pufferschicht) verhindert wird, läßt sich auch eine alternative Zellstruktur p⁺, n, n⁺ oder n⁺, p, p⁺ realisieren. Diese Alternative wird jedoch erfindungsgemäß nicht bevorzugt.

Die Herstellung der Zelle kann beispielsweise so erfolgen, dass auf ein ebenes oder strukturiertes borhaltiges Glas (für die Alternative phophorhaltiges Glas) eine amorphe Siliciumschicht einer Dicke zwischen 150 nm und 1,5 µm mit bekannten Verfahren wie einem plasmaunterstützten CVD-Verfahren abgeschieden wird. Anschließend wird die Schicht spurweise und dabei überlappend mit einem Überlappungsgrad von 2 bis 60 % mit dem Strahl eines Ar-Ionenlasers, eines frequenzverdoppelten Nd:YAG-Lasers, eines CO₂ - Lasers oder einer Laserdiode (Wellenlänge < 940 nm) bestrahlt. Die Überlappung soll so erfolgen, dass ein Teil der grobkörnigen Bereiche, die mit einer vorhergehenden Spur erzeugt wurden, wieder aufgeschmolzen wird. Dabei führt eine stärkere Überlappung zu größeren Kristalliten. Bei etwa 60% Überlappungsgrad ist allerdings nach den Beobachtungen der Erfinder eine Sättigung erreicht und die Kristallite wachsen nicht mehr.

Die Verfahrgeschwindigkeit des Laserstrahls über die zu kristallisierende Schicht beträgt 0,1 bis 50 cm/s und vorzugsweise 1 bis 10 cm/s. Die Leistungsdichte des Lasers wird bevorzugt auf 8 bis etwa 160 kW/cm² eingestellt. Der untere Leistungsbereich ist bei kleiner Verfahrgeschwindigkeit, der obere bei großer Verfahrgeschwindigkeit anzuwenden.

Es wurde mit Strahldimensionen in Verfahrrichtung von 50 bis 500 µm in dem angegebenen Verfahrgeschwindigkeitsbereich gearbeitet. Generell gilt, dass bei größeren Strahldimensionen die Geschwindigkeit entsprechend erhöht wird, so dass jeder Ort der Schicht für einige 10 µs bis einige ms bestrahlt wird. Die Schmelzdauer sollte dabei im Bereich 0,1 bis 10 ms liegen.

Während der Laserbestrahlung wird das Substrat durch eine Heizung auf eine Temperatur zwischen 400 und 700 °C gebracht.

Die Schicht wird während der Bestrahlung durch Diffusion von Bor oder Phosphor aus dem Glas dotiert, kann aber zusätzlich auch während der Beschichtung mit bekannten Verfahren durch Zusatz von gasförmigen Dotierstoffen dotiert werden. Auf diese Schicht wird ganzflächig oder bis auf ein Gebiet, wo der Metallkontakt aufgebracht wird, bis zum Erreichen der Absorberschichtdicke weiter amorphes Silicium mit bekannten Verfahren abgeschieden, wobei während der Beschichtung, immer wenn eine Schicht von 5 bis 200 nm neu aufgebracht worden ist, diese mit einem gepulsten homogenisierten Excimerlaser bestrahlt wird. Durch die Bestrahlung mit Energiedichten von 200, vorzugsweise 450 bis 800 mJ/cm² wird die Schicht so kristallisiert, dass die Kristallstruktur von unten epitaktisch fortgesetzt wird. In Abhängigkeit vom Verhältnis der zu beschichtenden Fläche und der durch einen Excimerlaserimpuls bestrahlten Fläche, die von der Impulsenergie des Lasers abhängt, wird jeweils mit einem Laserimpuls oder mit mehreren Laserimpulsen epitaktisch kristallisiert, indem der Strahl des Excimerlasers so über dem beschichteten Substrat verschoben wird, dass die Bestrahlungsflächen aneinander anschließen. Durch Diffusion während der Excimerlaserbestrahlung wird eine Dotierung mit abfallender Konzentration in die Absorberschicht eingebracht, die aber auch noch während der Beschichtung zusätzlich dotiert werden kann.

Die darauf liegende Emitterschicht mit rauher Oberfläche wird so hergestellt, dass eine amorphe Siliciumschicht der Dicke von 5 bis 100 nm, bevorzugt 20 bis 100 nm, auf der Absorberschicht abgeschieden wird. Die Schicht wird während der Beschichtung n-dotiert (in der Alternative p-dotiert) und/oder anschließend mit einer dotandenhaltigen Schicht bedeckt, und mit einem UV-Laserstrahl z.B. eines Excimerlasers mit Energiedichten von 150 bis 800 mJ/cm² im UV-Bereich analog der im vorherigen Absatz geschilderten Vorgehensweise bestrahlt. Hierzu wird ein Strahl eines Excimerlasers schrittweise über dem beschichteteten Substrat verschoben. Abhängig von der Energiedichte setzt sich die multikristalline Kristallstruktur der Absorberschicht fort oder es entsteht bei Vorgabe kleinerer Fluenzwerte des Excimerlasers eine feinkörnige mikrokristalline Schicht. Diese Schicht wird mit der Metallschicht bedeckt. Diese wird vorzugsweise als Aluminiumschicht mit einer Dicke zwischen 100 nm bis zu einigen µm aufgebracht.

Wurden die Absorberschicht und die darauf liegenden Schichten ganzflächig aufgebracht, wird das Schichtpaket in einem Gebiet, wo der Metallkontakt auf der hochleitenden Keimschicht b1 aufgebracht werden soll, bis zur Oberfläche der Schicht b1 durch Ätzen oder Laserabtrag entfernt. Die Metallschichten werden durch Siebdruck oder andere konventionellen Verfahren aufgebracht.

Wahlweise ist das Substrat ein ebenes Glas mit einer Transformationstemperatur bevorzugt unter 600 °C. Nach einer weiteren Ausführung ist die Seite des Glases, auf der die Silicium-Schicht aufgebracht wird, angerauht oder strukturiert und wirkt lichtstreuend, wodurch der an der Grenzfläche Glas/Si rückreflektierte Lichtanteil reduziert wird. Die Dicke des Glassubstrats beträgt vorzugsweise 0,4 bis 10 mm.

In einer ersten Ausführung besteht die gesamte multikristalline Siliciumschicht aus Körnern, die lateral eine Ausdehnung größer als die gesamte Schichtdicke (Keimschicht plus Absorberschicht plus Emitterschicht) besitzen. Daher gibt es keine Korngrenzen, die parallel zur Schicht laufen und damit die Stromrichtung kreuzen. Vielmehr durchlaufen die Korngrenzen die gesamte Schichtdicke vom Substrat bis zur Emitteroberfläche durchgängig.

In einer zweiten Ausführung besteht nur der p-dotierte Teil der multikristallinen Schicht aus diesen großen Körnern. Der n-dotierte Emitterbereich besteht aus Kristalliten im Bereich von 5 bis 500 nm, was zu Oberflächenrauhigkeiten in der Dimension der Lichtwellenlänge führt.

Von den zahlreichen möglichen Ausführungen der erfindungsgemäßen Zelle und deren Herstellungsverfahren sind im folgenden zwei konkrete Beispiele angegeben.

### Ausführungsbeispiel I

### Verfahrensschritt 1

Eine 200 nm a-Si:H Schicht mit einem Wasserstoffgehalt von 3 Atom.% wird auf einem Borosilikatglas mit einem B₂O₃ Gehalt von 15 Gew.% durch einen Standard CVD-Prozess abgeschieden.

### Verfahrensschritt 2

Durch Bestrahlung der a-Si:H Schicht mit einem Nd:YAG- Laser (cw, frequenzverdoppelt, d.h. mit einer Wellenlänge von 532 nm) bei gaussförmigem Strahlquerschnitt mit einem Strahldurchmesser von 80 µm und einer Laserleistung von 3W (entsprechend einer Bestrahlungsintensität bzw. Leistungsdichte von 60 kW/cm²) und einer Verfahrgeschwindigkeit des Laserstrahls relativ zur Schicht von 5 cm/s mit einer Spurüberlappung von 40 % wird eine 200 nm dicke p⁺-dotierte multikristalline Keimschicht erzeugt. Das Substrat wird während der Bestrahlung z.B. mittels Strahlern oder anderer konventioneller Heizmittel auf einer Temperatur von 600 °C gehalten.

### Verfahrensschritt 3

Es wird eine Absorberschicht von 5 µm Dicke durch kontinuierliche Beschichtung der Keimschicht mit p-dotiertem a-Si im plasmaunterstützten CVD-Verfahren mit Diboran erzeugt, wobei jeweils nach Erreichen einer Schichtdicke von 30 nm eine Bestrahlung mit einem gepulsten Excimerlaser erfolgt mit den Parametern: Wellenlänge 248 nm, Impulsdauer 30 ns, Fluenz 500 mJ/cm². Ist die aufgebrachte a-Si-Schicht wasserstoffhaltig, so wird mit einer Doppelimpulstechnik gearbeitet, d.h. 1/100s vor dem oben definierten Laserimpuls wird mit einem Laserimpuls vom Excimerlaser mit einer Fluenz von 150 mJ/cm² der Wasserstoff ausgetrieben. Die Temperatur des Substrats beträgt 400 °C. Im Ausführungsbeispiel werden bei der Aufbringung der Absorberschicht Kontaktbereiche zur Keimschicht ausgespart.

### Verfahrensschritt 4

Die Emitterschicht wird durch Aufbringen einer n-dotierten a-Si-Schicht der Dicke 30 nm durch einen CVD-Prozeß mit Phosphin als Dotiergas und einer Bestrahlung analog zu Schritt 3 erzeugt.

### Verfahrensschritt 5

Die Kontaktierung erfolgt durch großflächige Metallbeschichtung des Emitters und Aufbringen von Metallstreifen auf die p⁺-Keimschicht in den freigelassenen Bereichen, jeweils durch Siebdruck.

### Ausführungsbeispiel II

### Verfahrensschritt 1

Eine 400 nm dicke α-Si:H Schicht wird ansonsten wie im Ausführungsbeispiel 1, Schritt 1, abgeschieden.

### Verfahrensschritt 2

Durch Bestrahlung der a-Si:H Schicht mit einem Diodenlaser (cw, Wellenlänge von 806 nm) bei gaussförmigem Strahlquerschnitt mit einem Strahldurchmesser von 400 µm und einer Laserleistung von 14W (entsprechend einer Bestrahlungsintensität bzw. Leistungsdichte von 12 kW/cm²) und einer Verfahrgeschwindigkeit des Laserstrahls relativ zur Schicht von 0,5 cm/s mit einer Spurüberlappung von 40 % wird eine 400 nm dicke p⁺-dotierte multikristalline Keimschicht erzeugt. Das Substrat wird während der Bestrahlung wiederum auf einer Temperatur von 600 °C gehalten.

### Verfahrensschritt 3

Es wird eine Absorberschicht von 5 µm Dicke durch kontinuierliche Beschichtung der Keimschicht mit a-Si im plasmaunterstützten CVD-Verfahren erzeugt, wobei jeweils nach Erreichen einer Schichtdicke von 20 nm eine Bestrahlung mit einem gepulsten Excimerlaser erfolgt mit den Parametern: Wellenlänge 248 nm, Impulsdauer 30 ns, Fluenz 450 mJ/cm². Ansonsten wird wie im Ausführungsbeispiel I, Schritt 3 vorgegangen.

### Verfahrensschritt 4

Die Emitterschicht wird mit einer Dicke von 20 nm und ansonsten wie im Ausführungsbeispiel I, Schritt 4, erzeugt.

Verfahrensschritt 5 erfolgt analog wie im Ausführungsbeispiel I.

In den Ausführungsbeispielen wurde mit erhöhter Substrattemperatur gearbeitet, um den Einbau von Wasserstoff in die amorphe Schicht zu begrenzen. Man könnte auch bei niedrigeren Temperaturen bis hin zur Raumtemperatur arbeiten. In diesem Fall wendet man eine an sich bekannte zusätzliche UV-Laserbestrahlung mit niedrigen Fluenzen zur Wasserstoffaustreibung an.

## Patentansprüche

1. Multikristalline laserkristallisierte Silicium-Dünnschicht-Solarzelle auf einem Glassubstrat (a), die für eine Beleuchtung von der Substratseite ausgelegt ist, aufweisend:
eine mindestens 2 µm dicke laserkristallisierte multikristalline Siliciumschicht (b1, b2), deren unterer auf dem Substrat (a) liegender, als Keimschicht und gleichzeitig als untere transparente Elektrode dienender Schichtbereich (b1) p-dotiert oder in einer alternativen Ausführung n-dotiert ist, und deren zweiter vom Substrat abgewandter Schichtbereich (b2), der auf der Keimschicht epitaktisch kristallisiert und schwächer p-dotiert, in der alternativen Ausführung entsprechend schwächer n-dotiert ist als die Keimschicht, als Absorberschicht dient, wobei die laterale Kantenlänge der Kristallite in der multikristallinen Schicht (b1, b2) größer als die Dicke dieser Schicht ist und die Korngrenzen der Kristallite die Schicht (b1, b2) durchgehend durchlaufen, wobei die Keimschicht (b1) bei einer Dicke von 150 nm bis 1,5 µm eine Dotierung mit 10¹⁸ bis 6 x 10²⁰ cm⁻³ Dotieratomen aufweist,
eine auf der Siliciumschicht (b1, b2) liegende laserkristallisierte n-dotierte, in der alternativen Ausführung p-dotierte, als Emitterschicht dienende multikristalline oder mikrokristalline Siliciumschicht (c),
eine rückreflektierende Kontaktschicht (A1) als obere Elektrode auf der Emitterschicht (c), und
Kontaktbereiche, die auf freiliegenden Teilen der Keimschicht aufgebracht sind.

2. Solarzelle nach Anspruch 1, **dadurch gekennzeichnet,**
**dass** die Emitterschicht (c) eine Dicke zwischen 5 nm und 100 nm aufweist und wahlweise so beschaffen ist, dass
a) die großen Kristallite der die Keimschicht (b1) und Absorberschicht (b2) umfassenden laserkristallisierten multikristallinen Siliciumschicht sich auch durch die Emitterschicht (c) hindurch fortsetzen, oder
b) die Kristallite der Emitterschicht im Größenbereich zwischen 5 bis 500 nm liegen.

3. Solarzelle nach Anspruch 1 oder Anspruch 2, **dadurch gekennzeichnet,**
**dass** die Absorberschicht (b2) bei einer Dicke von 1 µm bis maximal etwa 30 µm eine Dotierung zwischen 10¹⁵ bis 10¹⁸ cm⁻³ Dotieratomen aufweist, die homogen ist oder ausgehend von der Grenzfläche zur Keimschicht zur Emitterschicht hin abnimmt, und dass die Emitterschicht (c) eine Dotierung von etwa 10¹⁸ bis 2 x 10²¹ cm⁻³ Dotieratomen aufweist.

4. Solarzelle nach einem der vorhergehenden Ansprüche, **dadurch gekennzeichnet,**
**dass** bei p-dotierter Keim- und Absorberschicht (b1, b2) Dotieratome der Schichten in Form von Bor vorliegen und hierzu das Substrat als Dotieratomlieferant vorzugsweise ein borhaltiges Glassubstrat wie Borosilikatglas ist, und dass bei n-dotierter Keim- und Absorberschicht (b1, b2) Dotieratome der Schichten in Form von Phosphor vorliegen und hierzu das Glassubstrat als Dotieratomlieferant vorzugsweise ein phosphorhaltiges Glassubstrat ist.

5. Solarzelle nach einem der vorhergehenden Ansprüche, **dadurch gekennzeichnet, dass** die rückreflektierende Kontaktschicht eine hochspiegelnde Metallschicht (A1), vorzugsweise aus Aluminium oder Silber ist.

6. Solarzelle nach einem der vorhergehenden Ansprüche, **dadurch gekennzeichnet, dass** die als untere Elektrode dienende Keimschicht (b1) über Metallstreifen (A1) in freiliegenden Bereichen der Keimschicht kontaktiert ist.

7. Verfahren zum Herstellen der Solarzelle nach einem der vorhergehenden Ansprüche, in welchem
a) auf einem Glassubstrat eine amorphe oder mikrokristalline Siliciumschicht abgeschieden wird, die mit einem Dauerstrichlaser mit einer Wellenlänge im sichtbaren Spektralbereich oder nahen Infrarot zu der multikristallinen Keimschicht kristallisiert wird, in der eine Dotierung durch Diffusion von Dotieratomen aus dem Substrat und/oder durch Zugabe von Dotiergasen während der Abscheidung erzielt wird, wobei die Keimschicht (b1) bei einer Dicke von 150 nm bis 1,5 µm eine Dotierung mit 10¹⁸ bis 6 x 10²⁰ cm-3 Dotieratomen aufweist,
b) die Absorberschicht begleitet von einer schrittweisen epitaktischen Kristallisation durch Laserbestrahlung während der Abscheidung aufgebracht wird, wobei jeweils nach Aufbringen eines Bruchteils der Schichtdicke der Absorberschicht mit einem gepulsten UV-Laserstrahl bestrahlt wird und eine Dotierung durch Diffusion von Dotieratomen aus der Keimschicht während der Bestrahlung und/oder durch Zugabe von Dotiergasen während der Abscheidung erzielt wird, und dabei die aus Keimschicht und Absorberschicht bestehende multikristalline Schicht mit einer Dicke von mindestens 2 µm erzeugt wird, wobei die Absorberschicht schwächer dotiert ist als die Keimschicht und die gleiche Art der Dotierung wie die Keimschicht aufweist, wobei mit Fluenzen des UV-Laserstrahls zwischen 200 und 800 mJ/cm² gearbeitet wird,
c) die Emitterschicht als amorphe oder mikrokristalline Siliciumschicht auf der Absorberschicht aufgebracht wird, wobei die Kristallisation mit einem gepulsten UV-Laserstrahl vorgenommen wird und eine Dotierung durch Zugabe von Dotiergasen während der Abscheidung und/oder Aufbringen einer dotandenhaltigen Fremdschicht auf die Emitterschicht und Eintreiben der Dotanden durch Laserbestrahlung erzielt wird, wobei die Emitterschicht die entgegengesetzte Art der Dotierung wie die Keimschicht aufweist, wobei mit Fluenzen des UV-Laserstrahls zwischen 150 und 800 mJ/cm² gearbeitet wird, wobei die Kristallitgröße zu höheren Fluenzwerten hin zunimmt, und
d) auf der dann multikristallinen oder mikrokristallinen Emitterschicht eine reflektierende Schicht als Kontaktschicht aufgebracht wird sowie auf freiliegenden oder noch freizulegenden Teilen der Keimschicht Kontaktbereiche aufgebracht werden.

8. Verfahren nach Anspruch 7, **dadurch gekennzeichnet,**
**dass** der Bruchteil der Absorberschichtdicke im Schritt b) auf 5 bis 200 nm eingestellt wird.

9. Verfahren nach Anspruch 8, **dadurch gekennzeichnet,**
**dass** die Schicht, die durch Laserkristallisation in die Keimschicht umgewandelt wird, als amorphe wasserstoffhaltige oder wasserstofffreie Siliciumschicht durch bekannte Verfahren wie Plasma-CVD, Elektronenstrahlverdampfung oder Hot-Wire CVD abgeschieden wird, welche auch zum Aufbringen der Absorberschicht und der Emitterschicht angewendet werden.

10. Verfahren nach Anspruch 8 oder 9, **dadurch gekennzeichnet,**
**dass** im Schritt a) mit einer Verfahrgeschwindigkeit des Dauerstrich-Laserstrahls über die Keimschicht von 0,1 cm/s bis 50 cm/s und mit Leistungsdichten des Laserstrahls von 8 bis 160 kW/cm² gearbeitet wird, wobei der untere Leistungsbereich bei kleinerer Verfahrgeschwindigkeit angewendet wird und der obere Leistungsbereich bei großer Verfahrgeschwindigkeit angewendet wird und mit einem Überlappungsgrad überlappender Verfahrspuren des Strahls zwischen 2% und 60% kristallisiert wird.

11. Verfahren nach einem der Ansprüche 8 bis 10, **dadurch gekennzeichnet,**
**dass** das Substrat im Verfahrensschritt a) auf eine Temperatur zwischen etwa 400 und 700°C aufgeheizt wird und in den Verfahrensschritten b) und c) auf eine Temperatur zwischen 20 °C und 600 °C.

## Claims

1. Multicrystalline laser-crystallized silicon thin layer solar cell on a glass substrate (a), which is designed for illumination from the substrate side, comprising:
a laser-crystallized multicrystalline silicon layer (b1, b2) at least 2µm thick, whose lower layer region (b1) lying on the substrate (a) and used as a seed layer and, at the same time, as a lower transparent electrode, is p-doped or, in an alternative embodiment, is n-doped, and whose second layer region (b2) facing away from the substrate, which is epitaxially crystallized on the seed layer and is more weakly p-doped, in the alternative embodiment is correspondingly more weakly n-doped, than the seed layer, is used as an absorber layer, the lateral edge length of the crystallites in the multicrystalline layer (b1, b2) being greater than the thickness of this layer, and the grain boundaries of the crystallites running continuously through the layer (b1, b2), the seed layer (b1) at a layer thickness of 150 nm to 1.5 µm having a doping with 10¹⁸ to 6 × 10²⁰ cm⁻³ doping atoms,
a laser-crystallized n-doped multicrystalline or microcrystalline silicon layer (c), p-doped in the alternative embodiment, lying on the silicon layer (b1, b2) and used as an emitter layer,
a retroreflecting contact layer (A1) as an upper electrode on the emitter layer (c), and
contact regions which are applied to exposed parts of the seed layer.

2. Solar cell according to Claim 1, **characterized in that** the emitter layer (c) has a thickness between 5 nm and 100 nm and is optionally composed in such a way that
a) the large crystallites of the laser-crystallized multicrystalline silicon layer comprising the seed layer (b1) and absorber layer (b2) also continue through the emitter layer (c), or
b) the crystallites of the emitter layer lie in the size range between 5 and 500 nm.

3. Solar cell according to Claim 1 or Claim 2, **characterized**
**in that**, with a thickness of 1 µm to at most about 30 µm, the absorber layer (b2) has a doping between 10¹⁵ and 10¹⁸ cm⁻³ doping atoms which is homogeneous or decreases towards the emitter layer, starting from the interface with the seed layer, and
**in that** the emitter layer (c) has a doping of about 10¹⁸ to 2 × 10²¹ cm⁻³ doping atoms.

4. Solar cell according to one of the preceding claims, **characterized**
**in that**, in the case of a p-doped seed and absorber layer (b1, b2), doping atoms of the layers are present in the form of boron and, to this end, the substrate, as a doping atom supplier, is preferably a boron-containing glass substrate such as borosilicate glass, and
**in that**, in the case of an n-doped seed and absorber layer (b1, b2), doping atoms of the layers are present in the form of phosphorus and, to this end, the glass substrate, as doping atom supplier, is preferably a phosphorus-containing glass substrate.

5. Solar cell according to one of the preceding claims, **characterized**
**in that** the retroreflective contact layer is a highly reflective metal layer (A1), preferably of aluminium or silver.

6. Solar cell according to one of the preceding claims, **characterized**
**in that** contact is made with the seed layer (b1) used as the lower electrode via metal strips (A1) in exposed regions of the seed layer.

7. Process for the production of the solar cell according to one of the preceding claims, in which
a) an amorphous or microcrystalline silicon layer is deposited on a glass substrate, which layer is crystallized by a continuous wave laser having a wavelength in the visible spectral range or near infrared to form the multicrystalline seed layer, in which doping is achieved by means of diffusion of doping atoms from the substrate and/or by the addition of doping gases during the deposition, the seed layer (b1) at a layer thickness of 150 nm to 1.5 µm having a doping with 10¹⁸ to 6 × 10²⁰ cm⁻³ doping atoms,
b) the absorber layer is applied during the deposition, accompanied by stepwise epitaxial crystallization by means of laser irradiation, in each case, following the application of a fraction of the layer thickness, the absorber layer being irradiated with a pulsed UV laser beam and doping being achieved by means of diffusion of doping atoms from the seed layer during the irradiation and/or by the addition of doping gases during the deposition and, in the process, the multicrystalline layer consisting of seed layer and absorber layer being produced with a thickness of at least 2 µm, the absorber layer being more weakly doped than the seed layer and exhibiting the same type of doping as the seed layer, operations being carried out with fluxes of the UV laser beam of between 200 and 800 mJ/cm²,
c) the emitter layer is applied to the absorber layer as an amorphous or microcrystalline silicon layer, the crystallization being carried out with a pulsed UV laser beam and doping being achieved by means of the addition of doping gases during the deposition and/or the application of a dopant-containing separate layer to the emitter layer and driving the dopants in by means of laser irradiation, the emitter layer exhibiting the opposite type of doping to that of the seed layer, operations being carried out with fluxes of the UV laser beam of between 150 and 800 mJ/cm², the crystallite size increasing towards higher flux values, and
d) a reflective layer then being applied to the multicrystalline or microcrystalline emitter layer as a contact layer and also contact regions being applied to parts of the seed layer which are exposed or are still to be exposed.

8. Method according to Claim 7, **characterized**
**in that** the fraction of the absorber layer in step b) is set to 5 to 200 nm.

9. Method according to Claim 8, **characterized**
**in that** the layer which is converted into the seed layer by laser crystallization is deposited as an amorphous hydrogen-containing or hydrogen-free silicon layer by means of known processes such as plasma CVD, electron beam vapour deposition or hot wire CVD, which are also used to apply the absorber layer and the emitter layer.

10. Method according to Claim 8 or 9, **characterized**
**in that** in step a), operations are carried out with a speed of movement of the continuous wave laser beam over the seed layer of 0.1 cm/s to 50 cm/s and with power densities of the laser beam of 8 to 160 kW/cm², the lower power range being used in the case of a lower speed of movement and the upper power range being used in the case of a high speed of movement, and crystallization being carried out with a level of overlap of overlapping movement tracks of the beam of between 2% and 60%.

11. Method according to one of Claims 8 to 10, **characterized**
**in that** the substrate is heated up in method step a) to a temperature between about 400 and 700°C and in method steps b) and c) to a temperature between 20°C and 600°C.

## Revendications

1. Cellule solaire à couche mince de silicium multicristallin cristallisée par laser sur un substrat en verre (a), prévue pour une exposition du côté du substrat, comprenant :
une couche de silicium multicristallin cristallisée par laser (b1, b2), épaisse d'au moins 2 µm, dont la zone de couche (b1) inférieure reposant sur le substrat (a), servant de couche germinative et simultanément d'électrode inférieure transparente est dopée p, ou, dans une exécution alternative, dopée n, et dont la deuxième zone de couche (b2) tournée en éloignement du substrat, à cristallisation épitactique sur la couche germinative et plus faiblement dopée p que la couche germinative, et dans l'exécution alternative respectivement plus faiblement dopée n que celle-ci, sert de couche d'absorption, la longueur de bord latéral des cristallites dans la couche multicristalline (b1, b2) étant supérieure à l'épaisseur de ladite couche, et les limites de grain des cristallites traversant continûment la couche (b1, b2), la couche germinative (b1) présentant un dopage de 10¹⁸ à 6 × 10²⁰ cm⁻³ d'atomes dopeurs pour une épaisseur de 150 nm à 1,5 µm,
une couche de silicium multicristallin ou microcristallin (c) cristallisée par laser reposant sur la couche de silicium (b1, b2), dopée n, ou dopée p dans l'exécution alternative, servant de couche d'émission,
une couche de contact rétro-réfléchissante (A1) en tant qu'électrode supérieure sur la couche d'émission (c), et
des zones de contact appliquées sur les parties dégagées de la couche germinative.

2. Cellule solaire selon la revendication 1, **caractérisée en ce que**
la couche d'émission (c) présente une épaisseur comprise entre 5 nm et 100 nm et est optionnellement équipée en sorte que
a) les grands cristallites de la couche de silicium multicristallin cristallisée par laser comprenant la couche germinative (b1) et la couche d'absorption (b2) se prolongent aussi au travers de la couche d'émission (c), ou que
b) les cristallites de la couche d'émission soient d'un ordre de grandeur entre 5 et 500 nm.

3. Cellule solaire selon la revendication 1 ou la revendication 2, **caractérisée en ce que**
la couche d'absorption (b2) présente, pour une épaisseur de 1 µm à quelques 30 µm au maximum, un dopage de 10¹⁵ à 10¹⁸ cm⁻³ d'atomes dopeurs, qui est homogène ou décroît à partir de la surface de délimitation avec la couche germinative et vers la couche d'émission, et **en ce que** la couche d'émission (c) présente un dopage de quelque 10¹⁸ à 2 × 10²¹ cm⁻³ d'atomes dopeurs.

4. Cellule solaire selon l'une des revendications précédentes, **caractérisée en ce qu'**en cas de couches germinative et d'absorption (b1, b2) dotées p, des atomes dopeurs des couches sont présents sous forme de bore, le substrat étant à cet effet, en tant que fournisseur d'atomes dopeurs, préférentiellement un substrat en verre contenant du bore, tel que du verre au silicate de bore, et **en ce qu'**en cas de couches germinative et d'absorption (b1, b2) dotées n, des atomes dopeurs des couches sont présents sous forme de phosphore, le substrat en verre étant à cet effet, en tant que fournisseur d'atomes dopeurs, préférentiellement un substrat en verre contenant du phosphore.

5. Cellule solaire selon l'une des revendications précédentes, **caractérisée en ce que** la couche de contact rétro-réfléchissante est une couche métallique fortement réfléchissante (A1), de préférence en aluminium ou en argent.

6. Cellule solaire selon l'une des revendications précédentes, **caractérisée en ce que** la couche germinative (b1) servant d'électrode inférieure est contactée avec des pistes métalliques (A1) dans les zones dégagées de la couche germinative.

7. Procédé de fabrication de la cellule solaire selon l'une des revendications précédentes, dans lequel
a) une couche de silicium amorphe ou multicristallin est déposée sur un substrat en verre, cristallisée vers la couche germinative multicristalline par un laser continu avec une longueur d'onde comprise dans la plage spectrale visible ou dans l'infrarouge proche, un dopage y étant obtenu par diffusion d'atomes dopeurs du substrat et/ou par ajout de gaz dopeurs pendant le dépôt, la couche germinative (b1) présentant un dopage de 10¹⁸ à 6 × 10²⁰) cm⁻³ d'atomes dopeurs pour une épaisseur de 150 nm à 1,5 µm,
b) la couche d'absorption est appliquée pendant le dépôt, accompagnée d'une cristallisation épitactique graduelle par rayonnement laser, une exposition à un faisceau laser UV pulsé ayant lieu après chaque application d'une fraction d'épaisseur de la couche d'absorption, et un dopage obtenu par diffusion d'atomes dopeurs de la couche germinative pendant l'exposition et/ou par ajout de gaz dopeurs pendant le dépôt, la couche multicristalline composée de la couche germinative et de la couche d'absorption étant alors produite avec une épaisseur minimale de 2 µm, la couche d'absorption étant plus faiblement dopée que la couche germinative et pourvue du même type de dopage que la couche germinative, des fluences du faisceau laser UV comprises entre 200 et 800 mJ/cm² étant utilisées,
c) la couche d'émission est appliquée en tant que couche de silicium amorphe ou microcristalline sur la couche d'absorption, la cristallisation étant exécutée avec un faisceau laser UV pulsé, et un dopage par ajout de gaz de dopage pendant le dépôt et/ou l'application d'une couche externe contenant des dopeurs sur la couche d'émission et implantation des dopeurs par rayonnement laser, la couche d'émission étant pourvue du type de dopage opposé à celui de la couche germinative, des fluences du faisceau laser UV comprises entre 150 et 800 mJ/cm² étant utilisées, la grandeur des cristallites augmentant à mesure que les valeurs de fluence s'élèvent, et
d) une couche réfléchissante est appliquée comme couche de contact sur la couche d'émission multicristalline ou microcristalline alors obtenue, et des zones de contact appliquées sur des parties dégagées ou restant à dégager de la couche germinative.

8. Procédé selon la revendication 7, **caractérisé en ce que** la fraction d'épaisseur de la couche d'absorption est réglée entre 5 et 200 nm dans l'étape b).

9. Procédé selon la revendication 8, **caractérisé en ce que** la couche transformée en couche germinative par cristallisation laser est déposée en tant que couche de silicium amorphe contenant de l'hydrogène ou exempte d'hydrogène au moyen de procédés connus tels que CVD plasma, vaporisation par faisceau d'électrons ou CVD à fil chaud, lesquels sont également utilisés pour l'application de la couche d'absorption et de la couche d'émission.

10. Procédé selon la revendication 8 ou la revendication 9, **caractérisé en ce que**
dans l'étape a), il est travaillé avec une vitesse de déplacement du faisceau laser continu comprise entre 0,1 cm/s et 50 cm/s sur la couche germinative et avec des densités de puissance du faisceau laser comprises entre 8 et 160 kW/cm², la plage de puissance inférieure étant utilisée pour une vitesse de déplacement réduite et la plage de puissance supérieure pour une vitesse de déplacement élevée, la cristallisation étant exécutée avec un degré de chevauchement des voies de déplacement chevauchantes du faisceau compris entre 2 % et 60 %.

11. Procédé selon l'une des revendications 8 à 10, **caractérisé en ce que** le substrat est chauffé à une température comprise entre 400 et 700°C environ dans l'étape a), et à une température comprise entre 20°C et 600°C environ dans les étapes b) et c).
